# EUROPEAN PATENT APPLICATION

(11) **EP 0 902 610 A1**
(43) Date of publication of application: **17.03.1999**
(21) Application number: 98830098.4
(22) Date of filing: 25.02.1998
(51) Int. Cl.: H05K 3/34, H01L 21/48, H01L 21/60, B23K 3/06

(54) **Arrangement of an ordered array of balls of solder alloy on respective pads of a baseplate of a BGA device**

(30) Priority: 10.09.1997 IT VA970030
(71) Applicant: STMicroelectronics S.r.l., 20041 Agrate Brianza (Milano) (IT)
(72) Inventor: Tondelli, Fulvio Silvio, 20146 Milano (IT); Cigada, Andrea Giovanni, 20155 Milano (IT)
(74) Representative: Pellegri, Alberto

(57) **Abstract**

Ball attach gravity system for disposing an ordered array of balls (3) of Sn-Pb eutectic soldering alloy on the surface of an electrical connection baseplate of a BGA packaged integrated circuit, comprising a first or upper plate (1) and second or lower plate (2), each provided with drilled areas (1a, 2a) having holes arranged according to said ordered array and of a diameter sufficient for the passage therethrough of a single ball (3), the two plates being mutually shiftable one (1) over the other (2), from a disalignment position among respective holes during a phase of arrangement of a ball (3) into each hole of the first plate (1) to a position of alignment between respective holes in a phase of releasing by gravity the balls (3) to drop on the surface of said baseplate, has means for loading said balls (3) in the holes of said preordering upper plate (1), consist of a bottomless container-drawer (4), containing a mass of free-flowing balls (3), shiftable over the surface of the upper plate (1) to a position geometrically superimposed to the drilled area (1a) of the upper plate (1) and to a position noncoincident with the drilled area (1a) of the upper plate (1).

## Description

The present invention relates to fabrication processes of integrated circuits and more in particular to methods and apparatuses employed for making BGA (Ball Grid Array) packagings of integrated circuits.

The ever increasing demand for reduction of the size of electronic systems is leading the industry of integrated devices to develop more efficient packages than traditional perimetral-pin packages, in order to permit a larger number of connections on a given board area.

The Ball Grid Array or briefly BGA package, has eutectic lead/tin soldering alloy globules or small balls disposed in an ordered array or grid on the lower surface of the integrated circuit.

This package configuration overcomes the limitation of the number of I/O pins of the integrated circuit, thus allowing for a substantial reduction of the size of the package.

The BGA packaging technology is very different from that of conventional plastic packages. In practice, this new packaging technology utilizes several processing steps that were originally developed for the industry of PC boards.

One of these key processes is the formation of small globules or balls of lead/tin eutectic soldering alloy whose diameter generally may range between 0,3 and 1,0 mm and their subsequent attachment on respective electrical connection pads of the card.

The method for forming globules of eutectic solder alloy of Pb-Sn is based either on bonding on the pads preformed solder balls placed thereon or on depositing over each pad a small quantity of soldering alloy and thereafter producing a ball or a globule by a heat treatment that refluidizes the eutectic alloy which, owing to its superficial tension, produces a body whose shape is at least partially spherical (globular).

The methods of bonding to the pads preformed balls of eutectic solder alloy disposed thereon rest on depositing a layer of flux paste on the electrical connection pads, onto which are placed preformed balls of eutectic soldering alloy.

A final heat treatment in an oven at a fluidization temperature of the alloy, bond the alloy balls to their respective pads while retaining because of superficial tension, a substantially globular shape of the solder alloy.

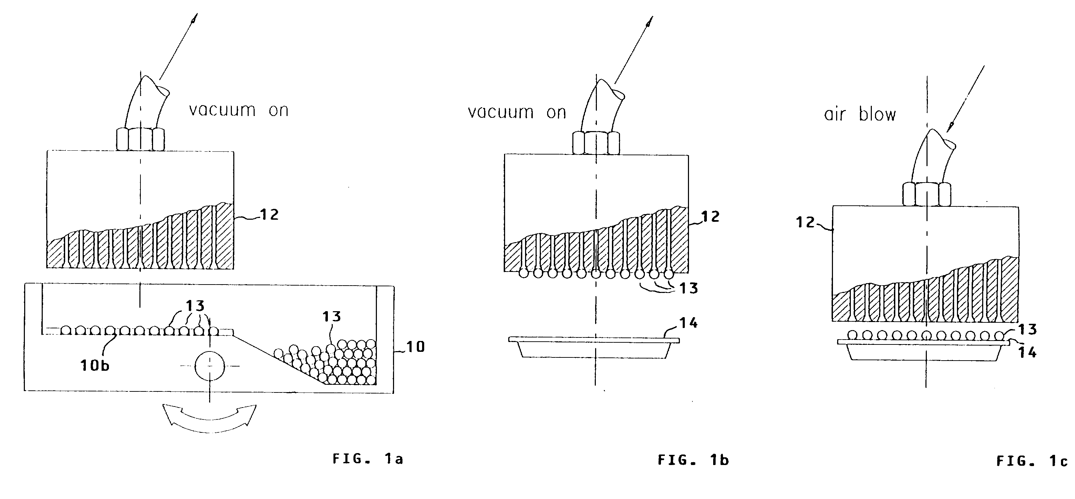

The majority of the systems for placing preformed balls of eutectic solder alloy onto the respective pads of electrical connection defined on the surface of a support and connection card of a BGA device employ a vacuum operated pick-up for transferring and releasing an ordered set of balls, according to a working scheme as depicted in Figures 1a, 1b and 1c.

According to this known technique, a dispenser 10 of balls of Sn-Pb eutectic solder alloy, configured for example like an oscillating drawer, produces an ordered array of balls 13, to be then transferred over a surface of the device, on the surface 10b provided with an ordered array of cavities which accommodate and retain a single ball upon oscillating the drawer 10.

This preordered array of balls is shifted by the use of a vacuum suction pick-up head 12, which is aligned above the preordered array of balls 3 of the dispenser drawer 10.

The balls are picked-up by the vacuum head 12 and transferred over the face 14 of the device on which there is a corresponding array of electrical connection pads, geometrically coinciding with the preordered array of balls.

The head 12 is lowered in perfect alignment down to the surface 14 of the device and by inverting the pressure the balls 13 are precisely dropped on the respective pads of electrical connection onto which a layer of flux paste had already been disposed, typically by screen printing.

This known technique has several drawbacks.

The balls dispenser, that is, the oscillating drawer 10 may require a vacuum suction through the ordered array of cavities in order to reliably retaining a ball into each cavity.

Often repeated oscillations of the drawer 10 are necessary to complete loading of the ordering of cavities.

Even the step of picking up the balls may become problematic due to intervening electrostatic phenomena that cause the balls to stick to the drilled plane 10b of the oscillating drawer 10.

Also the release of the balls on the pads precoated with flux paste may be rendered difficult by a build up of electrostatic charges.

These systems are also very sensitive to dust.

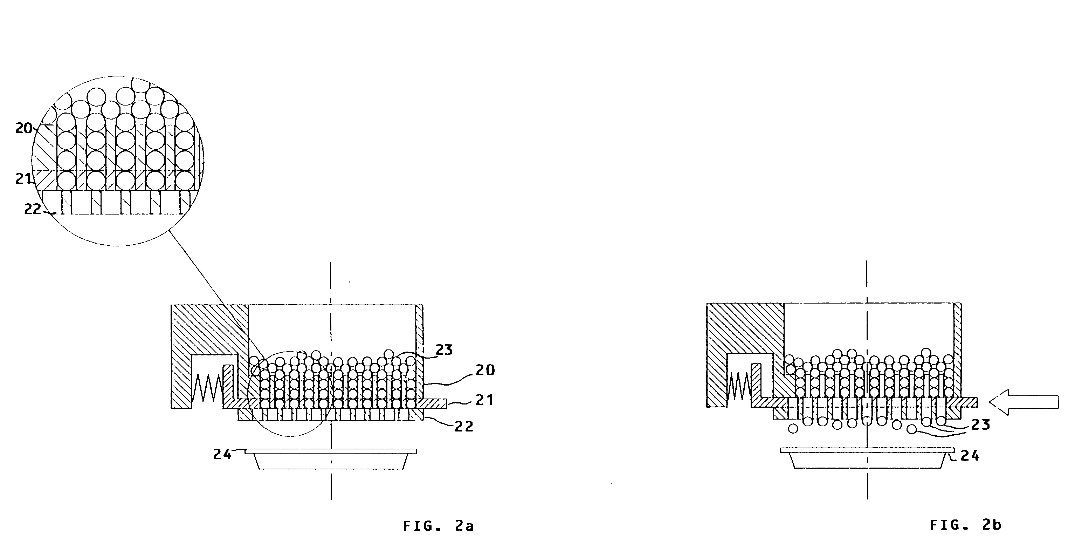

Another known system is schematically shown in Figures 2a and 2b. The system comprises three distinct plates: 20, 21 and 22, the middle one of which is capable of reciprocatingly shifting in respect to the other plates.

All three plates have an array of holes geometrically replicating the particular array of balls to be transferred and placed on the baseplate of the device.

The middle plate 21 is slightly thicker than the maximum diameter of the balls 23. The balls 23 may more or less completely fill the feed holes of the upper plate 20 and the holes of the middle plate 21 aligned with the fed holes of the upper plate 20.

Thereafter, the middle plate 21 is shifted into alignment of its holes with the holes of the bottom plate 22 thus allowing the ordered balls 23, shifted with the plate 21, to freely drop by gravity onto the receiving surface 24 beneath of the baseplate of a device properly aligned below the three-plate distributor.

Even this other known device has drawbacks. Firstly the loading of the upper grid or drilled plate 20 is not simple and often requires a vigorous shaking to ensure that all the feed holes of the upper plate are adequately filled with balls.

Balls are often damaged during the reciprocating motion of the middle plate 21 as some of them tend to clog the movement of it.

This may occur because the column of balls inside the correspondent feed hole of the upper plate 20 pushes on the ball contained in the corresponding hole of the intermediate plate 21.

On the other hand, a too small number of balls inside the holes of the upper distributing plate 20 may cause an incomplete loading of the middle grid.

The balls 23, that occasionally block the free movement of the intermediate plate 21, may suffer cuts and this leads to an accumulation of residues and fragments of solder inside the holes.

In case of a block, the device must be disassembled completely for carefully removing the residues that caused its failure (i.e. the stuck ball).

Even the phase of the release of the balls is delicate and badly affected by any accumulation of dust and solder residues in the mechanism.

Finally, this system does not permit a visual check either direct or by way of cameras of the completeness of the loading of all the holes of the upper distributing plate 20 due to the presence of a conspicuous number of balls over the grid assembly.

Vis-à-vis these drawbacks of the known systems, an outstandingly more reliable and effective system has now been conceived that though still relying on gravity for dropping the balls through a distributing and preordering grid, overcomes the above-noted drawbacks and limitations of the known systems.

According to an essential aspect of the system of the invention the presence of a third balls dispenser grid is avoided, and the disposition of single balls in the array of accommodating holes of a first grid plate whose thickness is commensurate to the diameter of the balls to be handled, is accomplished by the use of a bottomless container-drawer filled with a mass of free-flowing balls which moves over the upper face of said first grid plate to a position geometrically superimposed to the drilled area of said first plate, to be eventually advanced or retracted away from said position directly over the drilled area, before releasing by gravity the preordered balls by aligning an identical array of holes of a second grid plate shiftable in respect to the first plate and beneath it.

Completion of the loading of all the holes of the first grid plate with a single ball may be preventively ascertained visually or checked through a video camera system, and during the phase of the release of the so arranged balls, the mutual shifting of a plate in respect of the other is substantially free of potential risks of interference between the balls and the mutually shifting grid plates.

The loading of the balls in the accommodating holes of the first grid plate may be effected through a reciprocating movement or through a circular motion of the container-drawer or in any other way.

The balls carried by the container-drawer flow freely, and the movement of the container-drawer over a bottom surface that is constituted by the upper-grid first plate helps to maintain in a freely sliding condition the balls dragged along by the container-drawer.

The different aspects and advantages of the invention will be even more evident through the following description of an embodiment and by referring to the attached figures, wherein:
**Figures 1a, 1b** and **1c** depict the known ball ordering, ball transfer and deposition system employing a mobile vacuum pick-up head, already described above;
**Figures 2a** and **2b** illustrate the known gravity system already described above;
Fig**ures 3** and **4** illustrate an apparatus of the invention by highlighting its main aspects;
**Figures 5** to **9** illustrate the various functioning phases of the system of the invention.

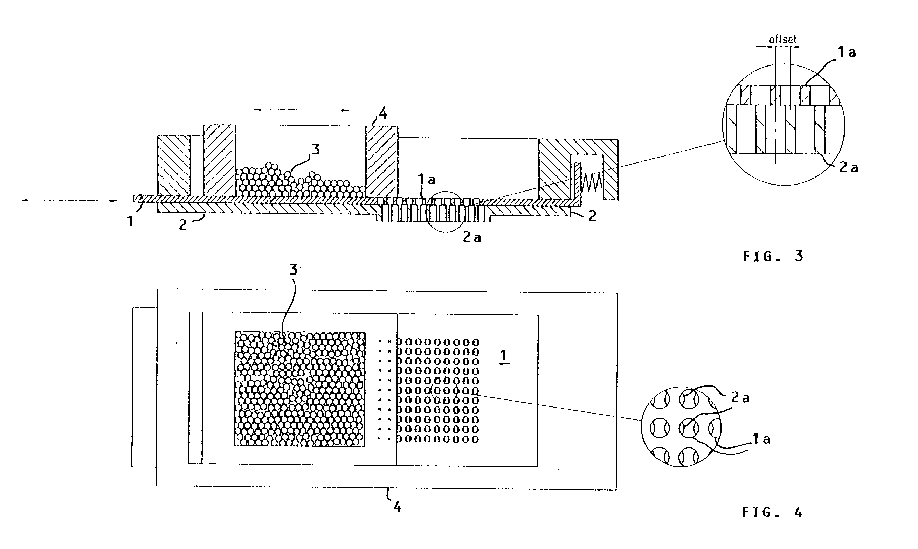

By referring to Figures 3 and 4, an apparatus made according to this invention consists of a first or upper grid plate 1 and of a second or lower grid plate 2, mutually shiftable, preferably the first over the second.

Each grid plate has a drilled area, respectively 1a and 2a, having holes arranged according to the ordered array of eutectic lead/tin solder balls or globules 3 to be placed on the baseplate of a BGA integrated device.

The diameter of the holes of the plates 1 and 2 is sufficiently larger than the diameter of the preferred alloy balls 3 in order to ensure an unhindered passage of a ball through the holes.

Commonly the eutectic lead/tin alloy solder balls 3 are preformed and screened so as to have a diameter substantially identical and which may range from 0,3 mm to 1,0 mm, depending on the application.

The holes of the drilled areas 1a and 2a of the two plates 1 and 2 have a diameter slightly greater than the diameter of the balls by a percentage of about 10% to 30% of the ball's diameter.

The holes of the drilled areas 1a and 2a of the plates 1 and 2 are normally out of alignment with each other by an offset sufficient to prevent the ball contained in a hole of the upper plate 1 from falling off. This offset may be equal to about a half of the ball's diameter or equal to the spacing between the holes of each array.

A container-drawer 4 rests on the upper face of the first grid plate 1 which constitutes the bottom of the drawer. The container-drawer 4 contains a mass of free-flowing balls 3.

The container-drawer 4 can be moved from a position geometrically adjacent to the drilled area 1a of the upper plate 1 to a position geometrically superimposed to the drilled area la of the plate 1 and viceversa.

Therefore, the prearrangement of the balls is effected according to a certain ordering array of holes of the upper plate 1, whose thickness may be greater than the diameter of the balls by a quantity that is about a half of the ball diameter and preferably comprised between 50% and 10% of its diameter.

The thickness of the upper grid plate 1 may be also slightly less or equal to the balls diameter, however in this case the container-drawer 4 is held at an appropriate spacing distance from the surface of the plate 1, sufficient to avoid any interference with the individual balls accommodated in the ordering holes of the plate 1.

Upon shifting the container-drawer 4, also the mass of balls 3 contained in it is shifted along over the surface of the upper plate 1, as far as eventually covering the drilled area la of the plate so that all the holes that are present in the area la of the plate receive and accommodate a single ball. This may occur with the moving over the drilled area of the mass of free-flowing balls or even during the successive movement away or beyond the drilled area 1a by the container-drawer 4.

Although the illustrated example depicts a system that employs a motion of the container-drawer 4 on the surface of the upper grid plate 1 of the device of the invention, it is indeed easy to understand how, in a different embodiment of the same device, the container-drawer may for example move circularly or otherwise along a closed path, passing over drilled areas la and over nondrilled area in succession.

In the latter case the two plates 1 and 2 could be circular and the intermittent alignment and disalignment of the holes of their drilled areas may occur by a reciprocating rotation of one in respect to the other.

The loading of all the holes of plate 1 when the container-drawer 4 (that is by the mass of balls 3 contained in it) moves over its drilled area 1a, can be visually checked by an operator or ascertained by dedicated automatic sensing means employing a camera, in order to confirm the ordering of a complete array of eutectic lead/tin balls to be dropped onto the baseplate of a device alignedly presented underneath the drilled area of the lower grid plate 2. Should the loading result incomplete, the container-drawer 4 may be moved again over the drilled zone la of the grid plate 1 until the loading is complete.

The successive phase of dropping of the solder balls prearranged in the grid constituted by the holes of the area la of the upper plate 1, onto the face of the electrical connection baseplate card of a BGA integrated circuit, suitably aligned with the vertical projection of the holes of the area 2a of the lower plate 2 by gravity, may then take place by moving the upper plate 1 by a distance equal to the offset, thus aligning the holes of the respective drilled areas la and 2a of the two plates 1 and 2. The balls are allowed to fall off by gravity the holes of the zone 1a of the upper plate 1 though the holes of the zone 2a of the lower plate 2 and to drop on the respective pads of electrical connection defined on the surface of the baseplate of a BGA device, which are preventively coated with a layer of flux paste whose stickiness and rheological characteristics are such as to retain adhered thereto the dropped ball.

The BGA device, with his array preformed of balls of eutectic solder alloy, is heat treated in an oven up to a melting temperature of the eutectic Pb-Sn alloy, soldering it to the metal of the respective electric connection pad, while maintaining a globular or almost globular form of the solder, by virtue of its superficial tension.

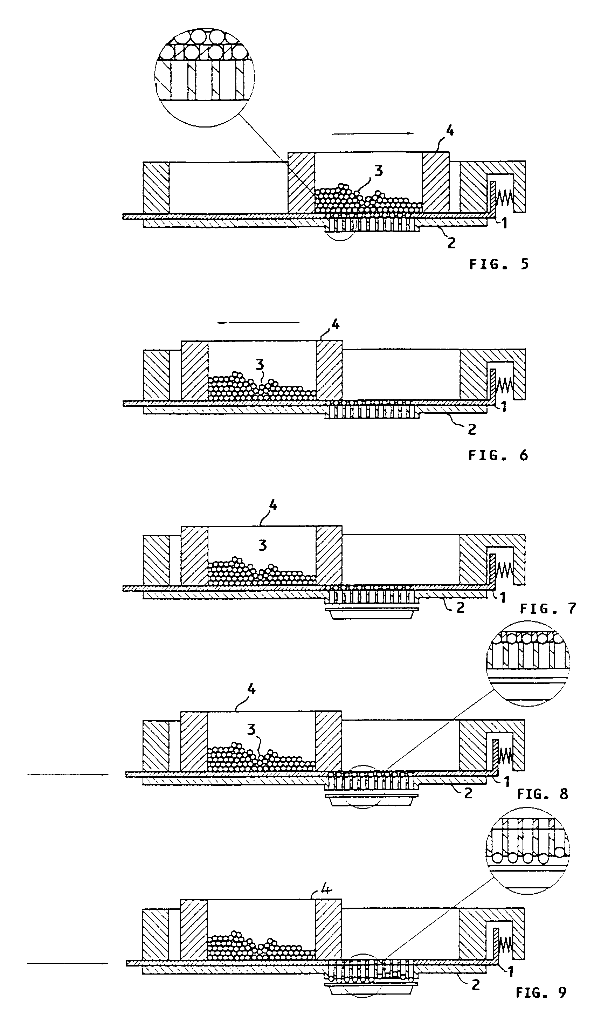

The various steps of the operation of the solder ball arranging and positioning system of the invention are illustrated in the series of Figures 5 to 9, relative to an embodiment of the device with a container-drawer 4 having a reciprocating alternative linear movement over the face of the upper grid plate 1, wherein a reciprocating movement of the upper plate 1 over the layer plate 2 is employed for aligning and offsetting the holes of their respective drilled areas 1a and 2a.

It is evident that the device of the invention can also be implemented in a way that the upper plate 1 remains fixed, while the lower plate 2 is moved by a distance equivalent to the offset at rest for releasing by gravity the balls arranged in the holes of the upper plate 1. Obviously, also in this case the BGA device receiving the balls must be aligned with the holes of the fixed plate, in this case with those of the upper plate 1.

The materials with which the two superposed mutually shiftable grid plates 1 and 2, as well as the moving container-drawer 4, may be constructed are: steel, bronze, brass and other metallic materials with a relatively low coefficient of friction. A nonmetallic material may also be used such as for example like for example nylon, PTFE, ceramic or cermet composites.

## Claims

1. Ball attach gravity system for disposing an ordered array of balls (3) of Sn-Pb eutectic soldering alloy on the surface of an electrical connection baseplate of a BGA packaged integrated circuit, comprising a first or upper plate (1) and second or lower plate (2), each provided with drilled areas (1a, 2a) having holes arranged according to said ordered array and of a diameter sufficient for the passage therethrough of a single ball (3), mutually shiftable one (1) over the other (2), from a disalignment position among respective holes during a phase of arrangement of a ball (3) into each hole of the first plate (1) to a position of alignment between respective holes in a phase of releasing by gravity the balls (3) to drop on the surface of said baseplate, and means for loading said balls (3) in the holes of said preordering upper plate (1), characterized in that said means for loading consist of a bottomless container-drawer (4), containing a mass of free-flowing balls (3), shiftable over the surface of said upper plate (1) to a position geometrically superimposed to the drilled area (1a) of said upper plate (1) and to a position noncoincident with said drilled area (1a) of said upper plate (1).

2. The system of claim 1, wherein said first plate (1) has a thickness greater than the diameter of a ball (3) by a quantity less than half a diameter of the balls and said bottomless container-drawer (4) slidingly bear on the surface of said upper plate (1).

3. The system of claim 1, wherein said container-drawer (4) moves between said two positions with a reciprocating motion.

4. The system according to claim 1, wherein said container-drawer (4) moves between said two positions along a closed loop path.

5. The system according to claim 1, wherein said two plates (1, 2) mutually shift with a reciprocating motion between said two positions and for a distance equal to a fraction of the diameter of said holes.

6. The system according to claim 1, wherein said shifting plate is the upper plate (1).

7. The system according to claim 1, wherein the shifting plate is said lower plate (2).
